# EUROPEAN PATENT APPLICATION

(11) **EP 2 535 945 A1**
(43) Date of publication of application: **19.12.2012**
(21) Application number: 11742157.8
(22) Date of filing: 03.02.2011
(51) Int. Cl.: H01L 31/042, B65D 59/00, B65D 81/113

(54) **MODULE FOR PROTECTING PHOTOVOLTAIC PANEL**

(30) Priority: 10.02.2010 JP 2010027615
(71) Applicant: Sharp Corporation, Osaka-shi, Osaka 545-8522 (JP)
(72) Inventor: FUJITA Toshiyuki, Osaka-shi Osaka 545-8522 (JP); MIYATA Yoshiaki, Osaka-shi Osaka 545-8522 (JP); NAITOH Katsuyuki, Osaka-shi Osaka 545-8522 (JP); TAMATANI Eiji, Yokohama-shi Kanagawa 225-0011 (JP)
(74) Representative: Müller - Hoffmann & Partner
(86) International application number: PCT/JP2011/052252
(87) International publication number: WO 2011/099413

(57) **Abstract**

The object of this invention is to protect a solar panel with attaching a protection module to four corners of a solar panel. Another object is for preventing the protection module from falling off when a solar panel is lifted up or tilted. Further object is that protection modules prevent collapse of cargo piles when solar panels are accumulated. The protection module comprises perpendicular sidewalls 41 and stage-like insertion member 44. The sidewalls 41 cover two corner sides of the stacked solar panels. The insertion member 44 and the sidewalls 41 are molded integrally in such manner to connect two sides of the insertion member 44 to the inner surface 42 of the sidewalls 41. The insertion member 44 is inserted between the stacked solar panels. A bank 45 is formed on the upper surface of the insertion member 44. The bank 45 has hooking slopes 46 for holding the lower edge 34 of the frame of the solar panel by hooking on it. A terrace 47 is formed on the underside of the insertion member 44. The terrace 47 has a ridge 48 for grasping the slope 33 of the upper edge 32 of the frame.

## Description

### [Field of invention]

The present invention relates to a protection module for protecting a solar panel, especially the corner of a solar panel, inserted between the adjacent stacked solar panels when manufactured solar panels are stacked for storage and transport.

### [Background art of the invention]

A photovoltaic module for converting sunlight into electricity is manufactured as below. Photovoltaic layers made of silicon film and electric conductive layers are formed on the back of a glass board. Further, a protection layer of synthetic resin is formed on that surface. The fringe of a photovoltaic module is surrounded with a frame made of processed drawn metal of aluminum or aluminum alloy to build a solar panel.

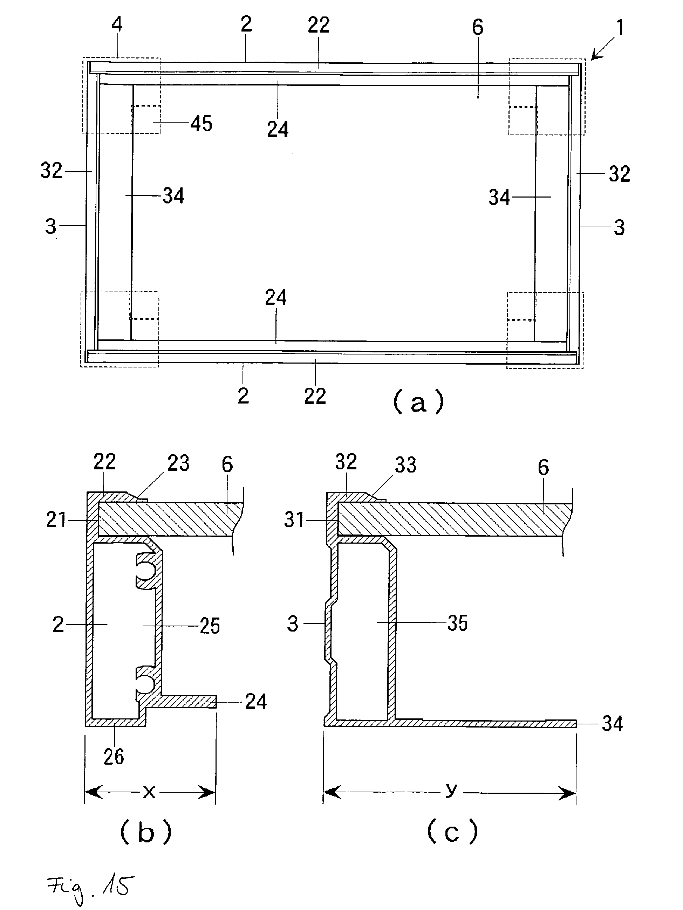

A frame is made of drawn metal with a connecting groove of square-U cross section. The drawn metal with the square-U connecting groove is mounted on all edges around the photovoltaic module to build a frame (refer to Fig.15).

The solar panel surrounded with frames as above is accumulated for storage and transport. At this time, it is necessary to prevent collapse of cargo piles and breakage of solar panels. Therefore, the protection modules are attached to four corners of a solar panel when stacked. It is already proposed in the following patent document 1.

### [Prior art documents]

### [Patent documents]

[Patent document 1] JP2006-032978A

### [Summary of the invention]

### [Problem to be solved by the invention]

The protection module as disclosed in the patent document 1 is for attaching to four corners of a solar panel. However, if they are attached to four corners of an accomplished solar panel, they fall off when the panel is lifted up. Therefore, the protection modules are not attached to solar panels until the solar panels are packaged.

A panel corner may be damaged at the period until packaging after completion of a solar panel. Then, it is required to equip a solar panel with a protection module immediately after completion of a solar panel.

The mass-produced solar panel is not a square but a rectangle. Two sorts of drawn metal are used for longer side and shorter side. Their cross-sections are different from each other. It is because of mechanical strength of the frame for supporting the photovoltaic module and the convenience of installation of panels.

The drawn metal 2 on longer side, as shown in the section of Fig. 15(b), has an upper edge 22 to form a connection groove 21 with square-U cross section for inserting the photovoltaic module and a lower edge 24. The drawn metal 3 on shorter side, as shown in the section of Fig. 15(c), has an upper edge 32 to form a connection groove 31 with square-U cross section for inserting the photovoltaic module and a lower edge 34.

These drawn metal 2 on longer side and the drawn metal 3 on shorter side are combined to build a frame 1 like a fine-art painting frame as shown in the plan view of Fig. 15(a).

Therefore, the protection module for a solar panel of this invention is invented to achieve the following objects. The protection module does not fall off if a solar panel is lifted up or tilted when the protection modules are attached to each corner of frame 1 as constituted above. And the protection module prevents collapse of cargo piles at the accumulation of solar panels.

### [Means to solve the problem]

A protection module for a solar panel of this invention is for protecting a solar panel as follows. The above-mentioned photovoltaic module is inserted to the frame to build a solar panel. The frame is made of processed drawn metal with upper edge forming a connection groove with square-U cross section and lower edge. The protection module has rectangular sidewalls to cover two corner edges of the stacked solar panel. The protection module has a stage-like insertion member. The insertion member is inserted between the stacked solar panels. The insertion member is molded integrally with connecting its two edges to the sidewalls. A bank is formed on the top surface of the insertion member. The bank has hooking slopes for hooking on lower edges of the frame. Terraces with ridge for grasping upper edges of the frame are formed on the underside of the insertion member.

### [Advantages of the invention]

The protection module of this invention has following advantages. The protection modules protect a solar panel when attached to the corners of the accomplished solar panel. The protection modules do not fall off when the solar panel is lifted up or tilted. The protection modules prevent collapse of cargo piles at the accumulation of solar panels.

### [Brief description of the drawings]

[Figure 1] It shows a plan view of the first embodiment of the protection module of this invention.
[Figure 2] It shows a longitudinal section as cut at the line A-A in Figure 1.
[Figure 3] It shows a bottom view of the first embodiment of the protection module.
[Figure 4] It shows a figure to explain the state to attach the protection module of the first embodiment of this invention to the corner of a solar panel.
[Figure 5] It shows a longitudinal section to indicate the accumulated state of solar panels interposing the protection modules of the first embodiment of this invention.
[Figure 6] It shows a plan view of the second embodiment of the protection module of this invention.
[Figure 7] It shows a longitudinal section as cut at the line B-B in Figure 6.
[Figure 8] It shows a bottom view of the second embodiment of the protection module.
[Figure 9] It shows an upper perspective view (a) and a lower perspective view (b) of the protection module of the second embodiment.
[Figure 10] It shows a figure to explain the state of attaching the protection module of the second embodiment of this invention to the corner of a solar panel.
[Figure 11] It shows a plan view of the third embodiment of the protection module of this invention.
[Figure 12] It shows a side view of the third embodiment.
[Figure 13] It shows a figure to indicate the cut-processed state of both ends of the drawn metal to build frames.
[Figure 14] It shows a bottom view (a) and a cross section (b) of the corner of the frame, and a bottom view (c) of the main part of the corner of the frame to explain the usage state of the protection module of the third embodiment.
[Figure 15] It shows a plan view (a) of the frame used for the solar panel, a longitudinal section (b) of the drawn metal on longer side of the frame and a longitudinal section (c) of the drawn metal on shorter side of the frame.

### [Modes for carrying out the invention]

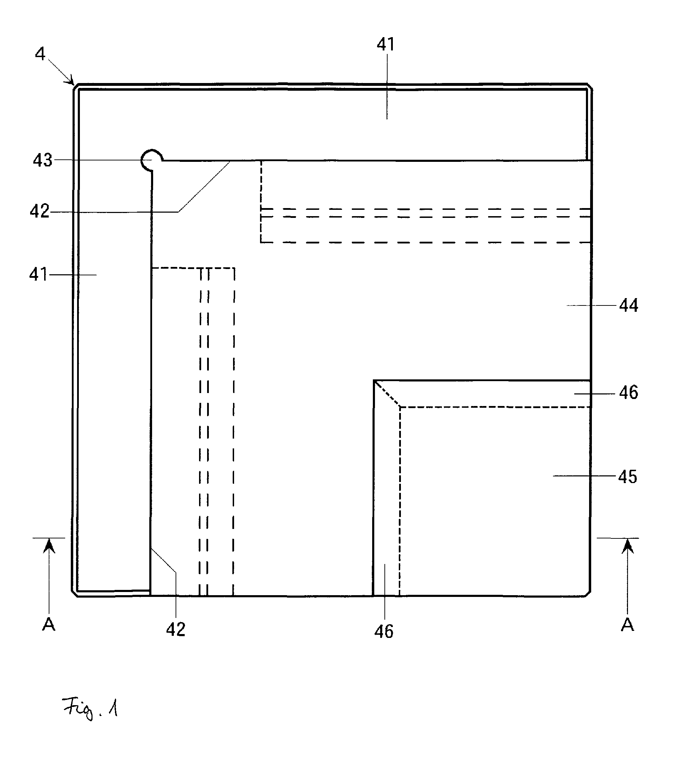

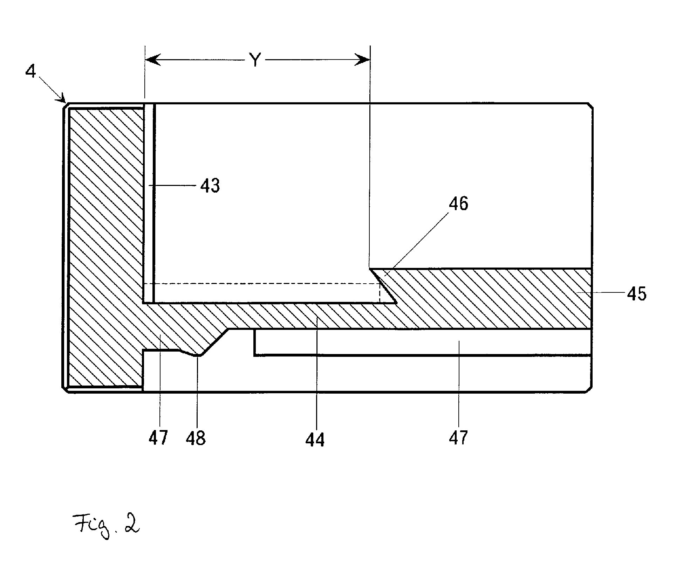

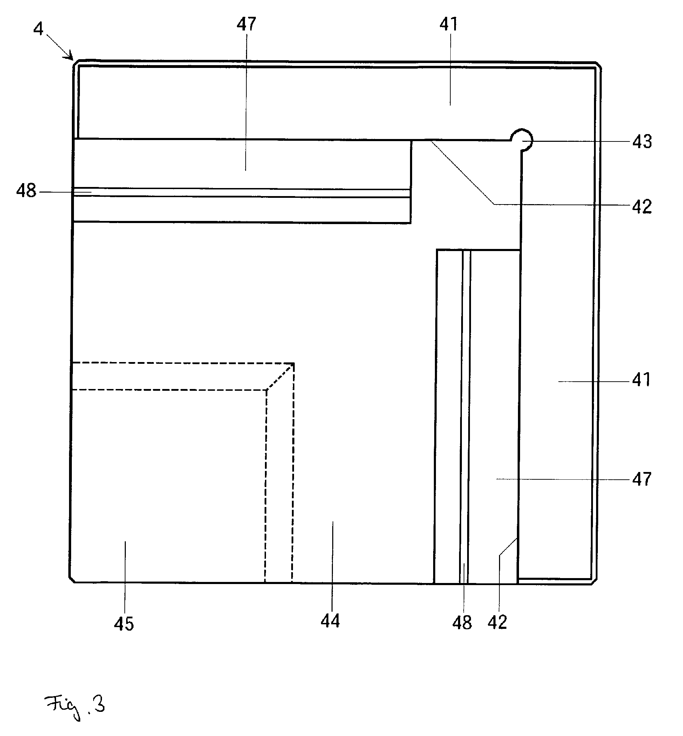

(The first embodiment) The first embodiment of the protection module for a solar panel of this invention is molded from synthetic resin as shown in the plan view of Figure 1, the cross section of Figure 2 and the bottom view of Figure 3. It is constituted of two sidewalls 41, 41 and a stage-like insertion member 44. Two sidewalls are perpendicular to the insertion member and intersect perpendicularly each other. Each edge of the insertion member reaches to the inside 42 of the sidewalls.

A square flat bank 45 is formed at the corner apart from two sidewalls 41, 41 on the upper surface of the stage-like insertion member 44. The bank has two hooking slopes 46, 46 with wedge-shaped cross-section. The slope is deeply cut to the inner side. These hooking slopes 46, 46 are for hooking on the edge face of the wide lower edge 34 of the drawn metal 3 as shown in the longitudinal section in Figure 15(c).

On the lower surface of this insertion member 44, two terraces 47, 47 are formed in parallel and adjacent to the inner surface 42 of the sidewalls 41, 41 except the corner area. The terrace 47 has a ridge 48 for hooking on the slopes 23, 23 formed inside of the upper edges 22, 32 of the drawn metals 2, 3 (refer to Figure 15).

In addition, the cylindrical hollow 43 formed in the inside corner where the sidewalls 41 and 41 meet is formed so that the corner of the solar panel might not be damaged when the corner of the solar panel would collide against the inside corner of the sidewalls.

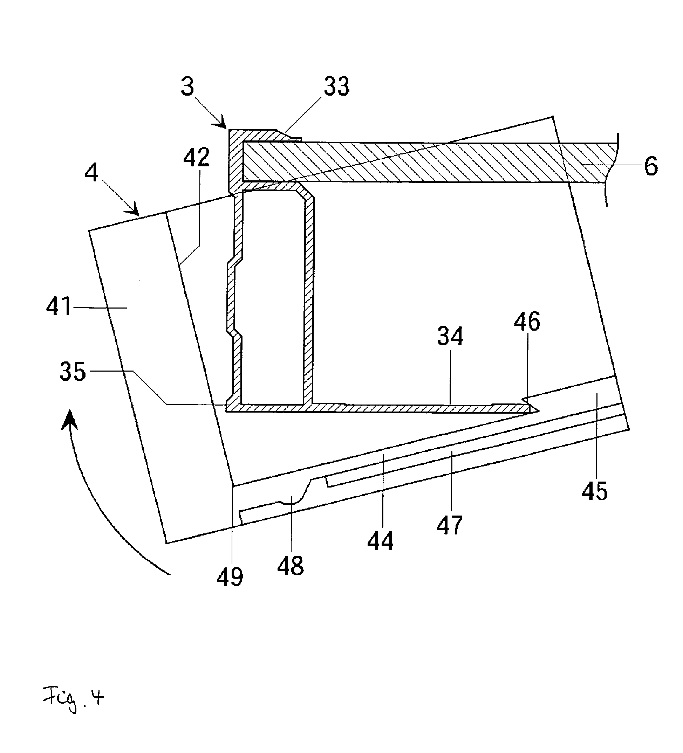

When the protection module as constituted as above is attached in the corner of the solar panel, as shown in Fig. 4, the shorter side of the solar panel is raised. The hooking slope 46 of the bank 45 of the protection module 4 is hooked on the tip of the lower edge 34 of the solar panel. As indicated by the arrow, the protection module 4 is turned upward.

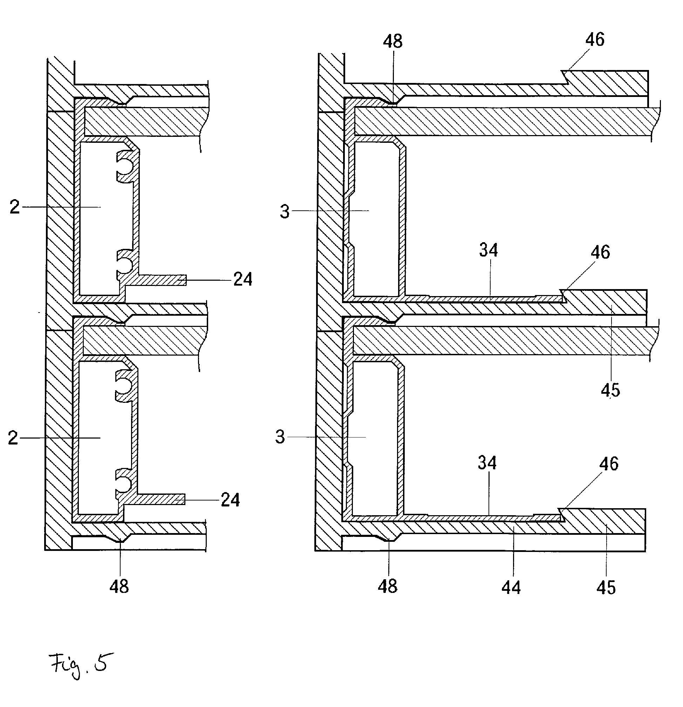

The distance Y (refer to Figure 2) between the hooking slopes 46, 46 and the inner surface 42 of the sidewalls 41, 41 of the protection module 4 is set up smaller than the width y (refer to Figure 15) of the lower edge 34 of the solar panel. Therefore, the corner 49 of the intersection of the sidewall 41 and the insertion member 44 fits to the corner 35 of the drawn metal 3 of the solar panel. At this time, the flat surface of the insertion member 44 carries out elastic deformation. As shown in Fig. 5, the protection module can be attached to the solar panel.

And, when the plural solar panels are stacked, as shown in the longitudinal section in Figure 5, the ridge 48 of the terrace 47 formed on the underside of the insertion member 44 grasps the slopes 23, 33 formed inside of the upper edges 22, 32 of the drawn metals 2, 3 of the solar panel stacked beneath. And also, the inner surface 42 of the sidewalls 41, 41 under the insertion member 44 clutches the upper outer surface of the drawn metals 2, 3 just beneath of the stack. Therefore, collapse of cargo piles would not be caused.

In addition, on the longer side and the shorter side of the frame 1, two sorts of drawn metals 2, 3 with different cross-section, especially widths x, y of the lower edges 24, 34, are used. Two hooking slopes 46, 46 are formed at the symmetric position with respect to the diagonal line of the protection module 4. Therefore, the protection module is constituted to be able to attach to any upper or lower corner of ether side of the frame 1.

(The second embodiment) The second embodiment of the protection module for a solar panel is that to reduce the used amount of the material while keeping mechanical strength.

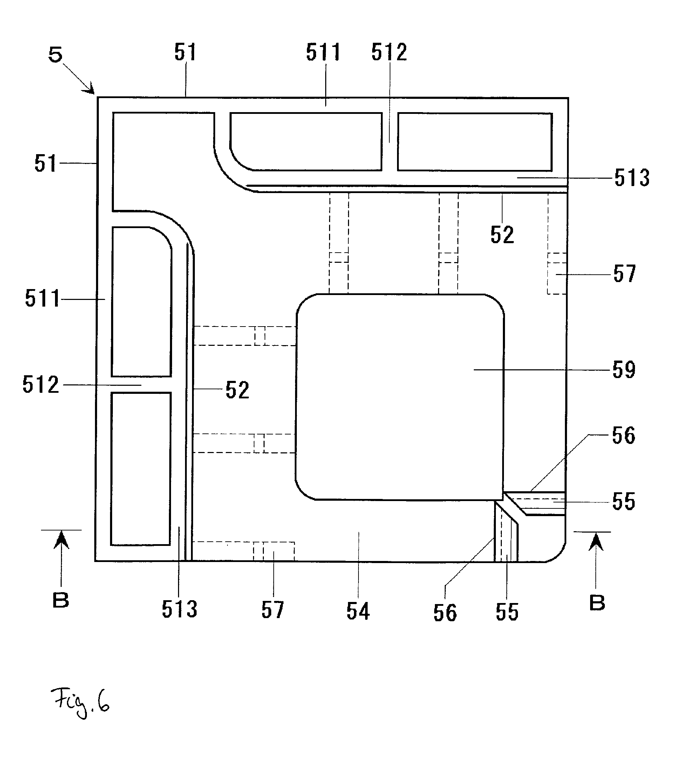

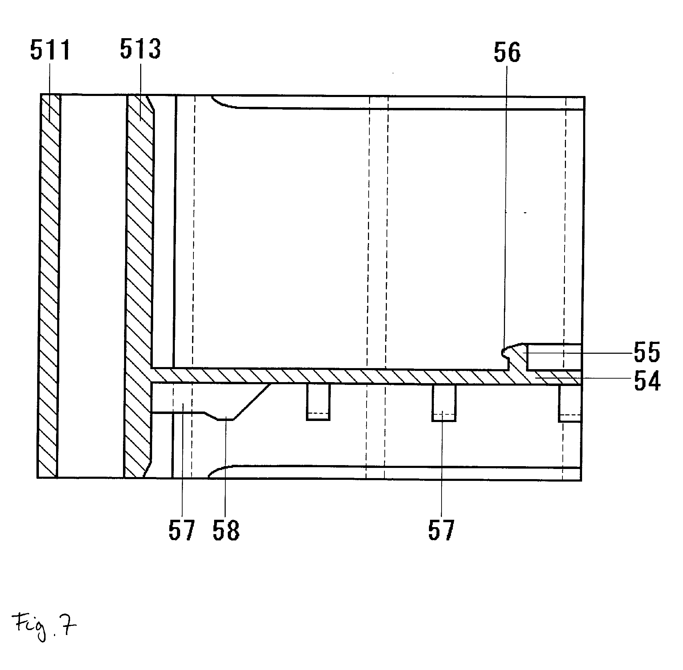

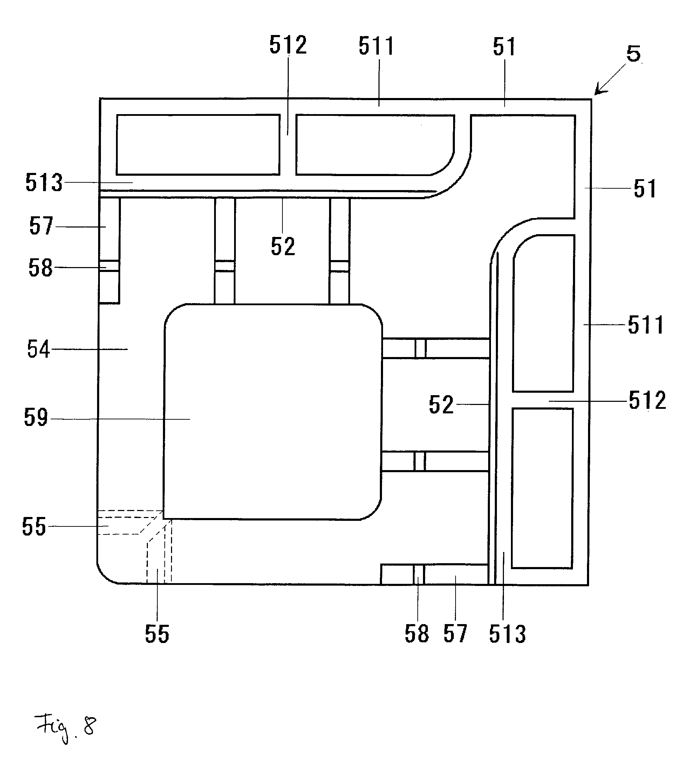

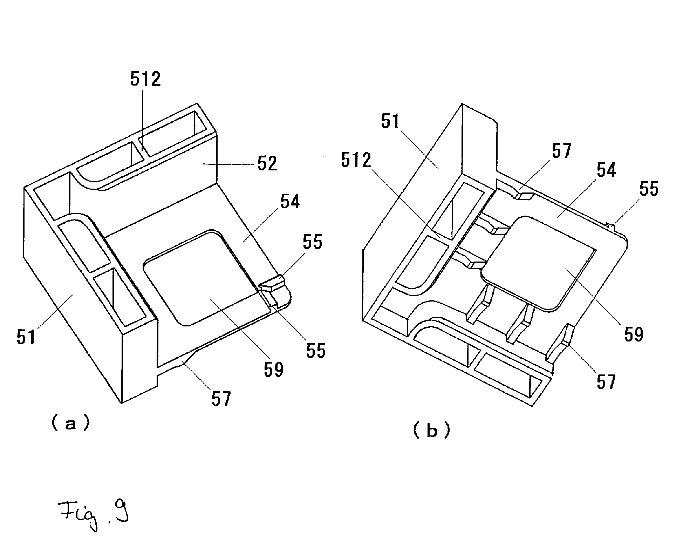

As shown in the plan view of Figure 6, in the cross section of Figure 7, in the bottom view of Figure 8 and in the perspective view of Figures 9 (a) and (b) , the protection module is constituted with two vertical sidewalls 51, 51 crossing perpendicular to each other and the stage-like insertion member 54. The sidewall is formed with flat tubular member that is made of outer wall 511 and inner wall 513 supported by the partition wall 512. Two edges of the insertion member contact the inner surfaces 52, 52 of the sidewalls 51, 51.

On the upper surface of this stage-like insertion member 54, at the corner apart from two sidewalls 51, 51, two banks 55, 55 are formed. Each bank is parallel to each sidewall crossing perpendicular to each other. The overhangs 56, 56 are formed at the top of the side surface against the sidewalls 51, 51 of these two banks 55, 55. These overhangs 56, 56 are, as shown in the longitudinal section in Figure 15, connected to the edge surface of the wide lower edge 34 of the drawn metal 3.

On the lower surface of this insertion member 54, plural terraces 57 are formed against the inner surfaces 52, 52 of the sidewalls 51, 51. The terrace has a ridge 58 for grasping the slopes 23, 23 formed inside of the upper edges 22, 32 of the drawn metals 2, 3.

In addition, the hole 59 at the center of the stage-like insertion member 44 is a hole opened at the part indifferent to the mechanical strength. It is opened to reduce the amount of the materials.

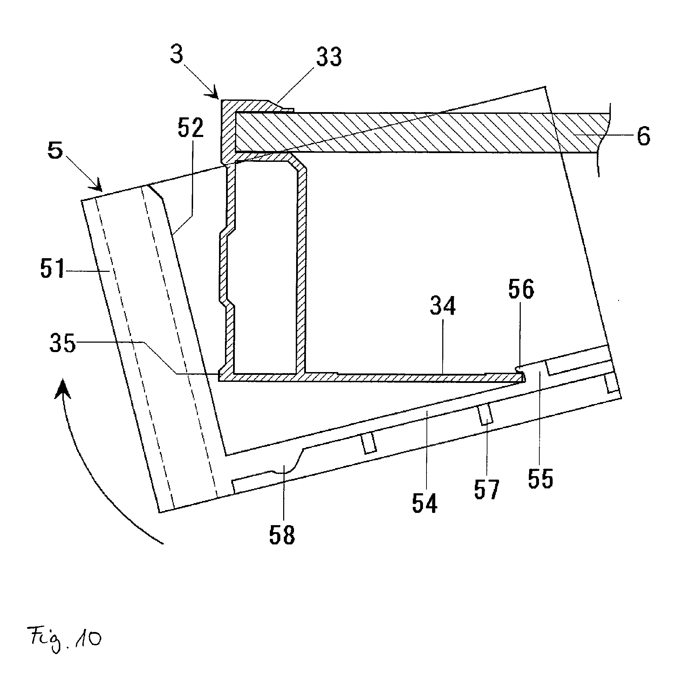

When the protection module constituted as above is attached to the corner of a solar panel, same as the first embodiment, as shown in Figure 10, lifting up the shorter side of the solar panel, the overhang 56 of the bank 55 of the protection module 5 is hooked on the front end of the lower edge 34 of the solar panel, as indicated by the arrow, the protection module 5 is turned up, the protection module 5 can be attached to the solar panel.

(The third embodiment) In the second embodiment as explained above, the overhang 56 of the bank 55 formed at the insertion member 54 is hooked on the lower edge 34 of the drawn material 3 on the shorter side of the frame 1. Then, the protection module 5 is attached to four corners of the photovoltaic module 6.

About the attached protection module 5, one hand of the overhangs 56 formed on two sides of the banks 55 is hooked on the lower edge 34 of the drawn metal 3 on the shorter side. But, it is not hooked on the lower edge 24 of the drawn metal 2 on longer side. Then, if it is attached with some offset in parallel to the drawn metal 3 on shorter side, a gap may arise between the inner surface of the protection module 5 and the side surface of the drawn metal 2 on longer side.

Therefore, in the third embodiment, the protection module 5 is constituted to attach to the corner of the frame 1 with positioning by hooking on both of the drawn metal 2 on longer side and the drawn metal 3 on shorter side.

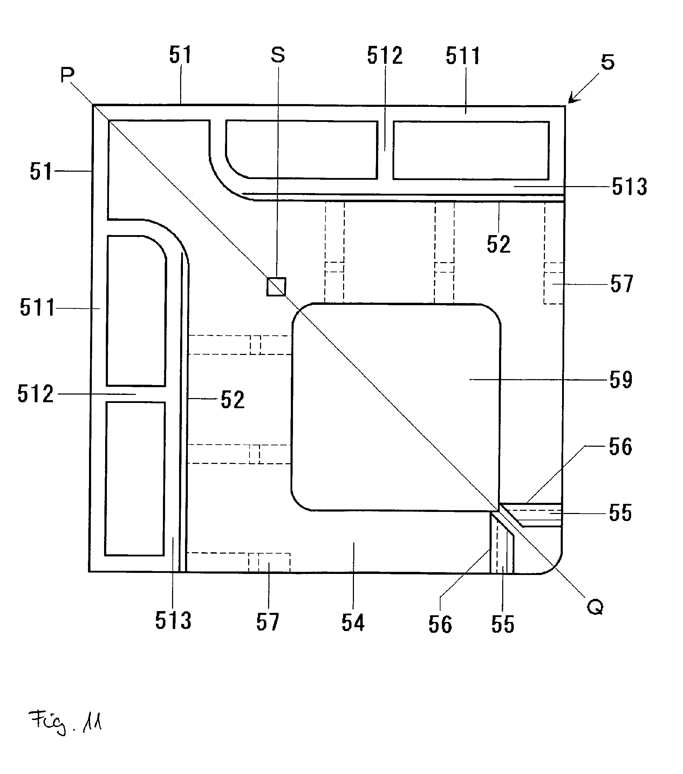

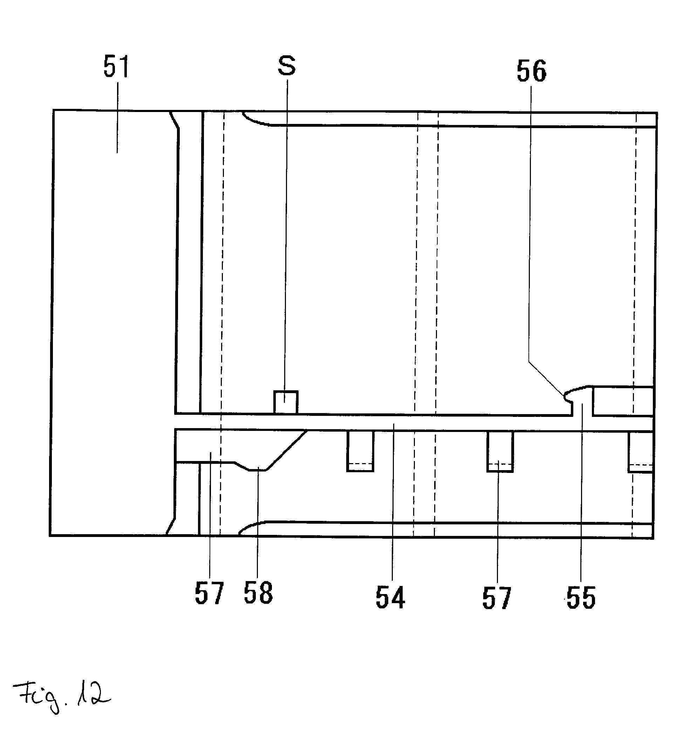

As shown in the plan view of Figure 11 and the side view of Figure 12, the protection module 50 of the third embodiment has a cubical boss S formed on the diagonal line P-Q of the insertion member 54. The other structure is the same as the protection module 5 of the second embodiment.

Next, the position to form the cubical boss S is explained.

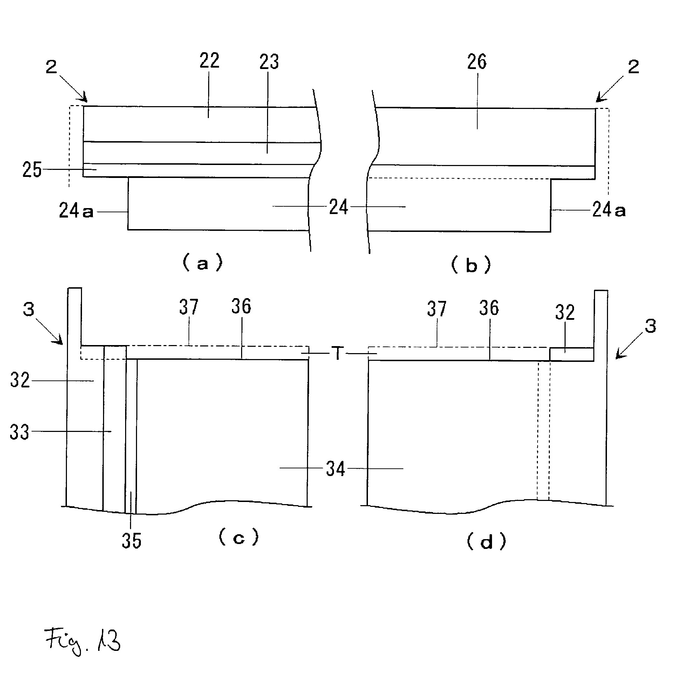

When both ends of the drawn metal 2 on longer side are processed by cutting, as shown in the plan view (a) and the bottom view (b) of Figure 13, in order to attach the tubular part 35 of the drawn metal 3 on shorter side, the step part 24a is formed by cutting the front end of the lower edge 24.

When both ends of the drawn metal 3 on shorter side are processed by cutting, as shown in the plan view (c) and the bottom view (d) of Figure 13, in order to attach the tubular part 25 of the drawn metal 2 on longer side, a notch part is formed by cutting the front end of the lower edge 34. At this time, it is cut at the line 36 deeper than the dotted broken line 37 reaching to the projection member 26 of the drawn metal 2 on longer side. It is cut deeply to form the gap T with the projection member 26 of the drawn metal 3 on shorter side.

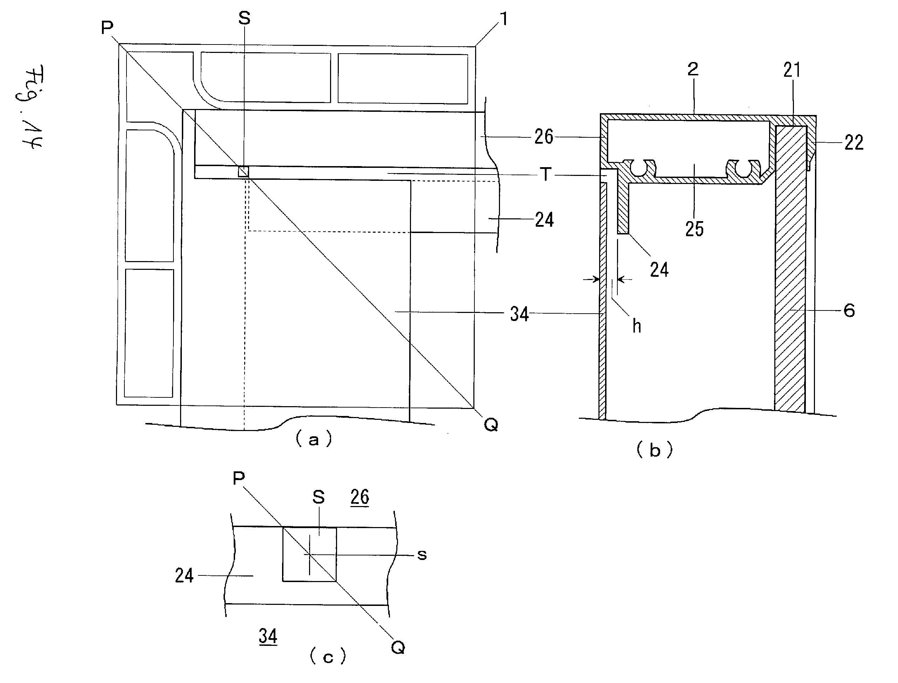

Thus, in the state where the drawn metal 2 on longer side and the drawn metal 3 on shorter side with both ends cut were connected at right angle, the gap T is formed as shown in the bottom view (a) of Figure 14. As shown in the cross section (b) of Figure 14, this gap T is closed with the lower edge 24 of the drawn metal 2 on longer side. But there is a gap h between the lower surface of the lower edge 24 of the drawn metal 2 on longer side and the upper surface of the lower edge 34 of the drawn metal 3 on shorter side.

As shown in the bottom view (c) of Figure 14 enlarged at the part of boss S, the boss S is square and its one side runs against the side of projection member 26. It is arranged so that the diagonal line P-Q goes through the center s of the boss S. And then, the height of this boss S is set up lower than the gap h.

When the boss S is arranged thus, in a symmetrical position with respect to the diagonal line P-Q of the protection module 4, two banks 55 and the boss S are formed. Therefore, it can be attached to anyone of four corners of the frame 1.

The boss S explained above is applicable also to the first embodiment. Moreover, a pillar is sufficient as the form of the boss S, without restricting to a square pole. It is enough that the pillar is arranged so that the diagonal line P-Q passes through the center of this pillar.

### [Reference codes]

- 1: frame
- 2: drawn metal on longer side
- 3: drawn metal on shorter side
- 23, 33: upper edge
- 24, 34: lower edge
- 25, 35: tubular part
- 26: projection member
- 4, 5: protection module
- 41, 51: sidewall
- 42, 52: inner surface of sidewall
- 44, 54: insertion member
- 45, 55: bank
- 46: hooking slope
- 56: overhang
- 6: photovoltaic module
- S: boss
- T: gap

## Claims

1. The protection module for protecting a solar panel made in such a manner to insert photovoltaic modules to the frame of processed drawn metal with upper edge forming a connection groove of square-U cross section and lower edge, comprising;
rectangular sidewalls to cover two edges at the corner of stacked solar panel, and
a stage-like insertion member molded integrally connecting two edges to the sidewalls for being inserted between the stacked solar panels,
wherein a bank with hooking slopes for hooking on the lower edge of the frame is formed on the top surface of the insertion member, and terraces with ridges for grasping upper edges of the frame are formed on the underside of the insertion member.

2. A protection module for protecting a solar panel made in such a manner to insert a photovoltaic module to a frame of processed drawn metal with upper edge forming the connection groove of square-U cross section and lower edge, comprising;
rectangular sidewalls to cover two edges at the corner of stacked solar panel, and
a stage-like insertion member molded integrally connecting two edges to the sidewalls for being inserted between the stacked solar panels,
wherein a bank with overhangs for hooking on lower edges of the frame is formed on the top surface of the insertion member, and terraces with ridges for hooking on upper edges of the frame is formed on the underside of the insertion member.

3. A protection module for protecting a solar panel made in such a manner to insert a photovoltaic module to a frame where is formed a gap between the downward projection member of the drawn metal on longer side and the cut-processed lower edge of the drawn metal on shorter side, wherein the longer side drawn metal has upper edge forming a connection groove of square-U cross section, lower edge and projection member on the bottom of lower edge, and the shorter side drawn metal has upper edge forming a connection groove of square-U cross section and lower edge, comprising;
rectangular sidewalls to cover two edges at the corner of stacked solar panel, and
a stage-like insertion member molded integrally connecting two edges to the sidewalls for being inserted between the stacked solar panels,
wherein a bank with overhangs for hooking on lower edge of the shorter side of the frame is formed at the symmetrical position with respect to the diagonal line of the protection module on the top surface of the insertion member and a boss to contact to the side surface of the projection member of the drawn metal on longer side are formed, and the center of the boss is positioned on the diagonal line of the protection module.
